# EUROPEAN PATENT APPLICATION

(11) **EP 4 697 901 A1**
(43) Date of publication of application: **18.02.2026**
(21) Application number: 25770400.7
(22) Date of filing: 03.07.2025
(51) Int. Cl.: H10F 77/20

(54) **PHOTOVOLTAIC MODULE, METHOD FOR MANUFACTURING PHOTOVOLTAIC MODULE, AND SCREEN PRINTING STENCIL**

(30) Priority: 05.07.2024 CN 202411594278; 28.10.2024 CN 202411516481
(71) Applicant: Longi Green Energy Technology Co., Ltd., Xi'an, Shaanxi 710100 (CN)
(72) Inventor: LI, Zhenguo, Shaanxi 710100 (CN); YANG, Dongsheng, Shaanxi 710100 (CN); WANG, Xiaofei, Shaanxi 710100 (CN); CHEN, Weiqiang, Shaanxi 710100 (CN); ZHANG, Huang, Shaanxi 710100 (CN); CHEN, Jun, Shaanxi 710100 (CN)
(74) Representative: Grünecker Patent- und Rechtsanwälte PartG mbB
(86) International application number: PCT/CN2025/106939
(87) International publication number: WO 2026/008033

(57) **Abstract**

The present application discloses a photovoltaic module, manufacturing methods thereof, and screen printing stencils, and relates to the field of photovoltaic technologies. The photovoltaic module includes a solar cell body, a connection portion, a first bonding layer, and an electrical connector. The solar cell body includes a first surface and a second surface arranged opposite to each other. The connection portion is arranged on the first surface. The connection portion includes a first connection portion and a second connection portion. The first connection portion and the second connection portion are arranged at intervals along a first direction. An area of the first connection portion is larger than an area of the second connection portion. The first bonding layer is arranged on a surface of the first connection portion away from the solar cell body. The first bonding layer includes at least two first bonding strips having a strip-shaped structure. The at least two first bonding strips extend along a second direction and are arranged at an interval along the first direction. The electrical connector is arranged on the first bonding layer. The electrical connector extends along the first direction and intersects with the at least two first bonding strips having the strip-shaped structure. The electrical connector is electrically connected to the first connection portion through the first bonding layer.

## Description

### CROSS-REFERENCE TO RELATED APPLICATIONS

The present application claims priorities to Chinese Patent Application No. 2024215942781, field with the China National Intellectual Administration Property on July 5, 2024 and entitled "A PHOTOVOLTAIC MODULE AND SCREEN PRINTING STENCILS", and Chinese Patent Application No. 2024115164811, filed with the China National Intellectual Administration Property on October 28, 2024 and entitled "A PHOTOVOLTAIC MODULE, MANUFACTURING METHODS THEREOF, AND SCREEN PRINTING STENCILS", which are incorporated herein by reference in their entities.

### TECHNICAL FIELD

The present application relates to the field of photovoltaic technologies, and specifically, to a photovoltaic module, manufacturing methods thereof, and screen printing stencils.

### BACKGROUND

A solar cell is a core component of a photovoltaic module, which converts solar energy into electric energy. A plurality of fingers extending along a first direction and arranged at intervals along a second direction are on a surface of the solar cell, so that currents generated by the solar cell are collected through the plurality of fingers. A plurality of pads arranged at intervals along the second direction are also arranged on the surface of the solar cell. Ribbons are connected to the fingers through the plurality of pads, to transfer the currents collected by the fingers.

In a related art, to improve reliability of the connection between the ribbons and the plurality of pads, tin layers are arranged between the pads.

However, because areas of some pads are relatively large and areas of the other pads are relatively small, phenomena such as insecure soldering and poor soldering easily occur in a process of soldering the ribbons to the pads, affecting reliability and photoelectric conversion efficiency of the photovoltaic module.

### SUMMARY

The present application discloses a photovoltaic module, manufacturing methods thereof, and screen printing stencils, to solve or at least partially solve the problem existing in the related art: because areas of some pads are relatively large and areas of the other pads are relatively small, phenomena such as insecure soldering and poor soldering occur in a process of soldering ribbons to pads, affecting reliability and photoelectric conversion efficiency of the photovoltaic module.

To solve the foregoing technical problem, the present application is implemented as follows:
According to a first aspect, the present application discloses a photovoltaic module. The photovoltaic module includes a solar cell body, a connection portion, a first bonding layer, and an electrical connector. The solar cell body includes a first surface and a second surface arranged opposite to each other. The connection portion is arranged on the first surface. The connection portion includes a first connection portion and a second connection portion. The first connection portion and the second connection portion are arranged at intervals along a first direction. An area of the first connection portion is larger than an area of the second connection portion. The first bonding layer is arranged on a surface of the first connection portion away from the solar cell body. The first bonding layer includes at least two first bonding strips having a strip-shaped structure. The at least two first bonding strips extend along a second direction and are arranged at an interval along the first direction. The second direction intersects with the first direction. The electrical connector is arranged on the first bonding layer. The electrical connector extends along the first direction and intersects with the at least two first bonding strips having the strip-shaped structure. The electrical connector is electrically connected to the first connection portion through the first bonding layer.

In this embodiment of the present application, the first bonding layer is arranged on the surface of the first connection portion away from the solar cell body, the first bonding layer includes the at least two first bonding strips, the at least two first bonding strips are arranged at an interval along the first direction, and the first bonding strips have the strip-shaped structure extending along the second direction. The electrical connector is arranged on the first bonding layer, and the electrical connector extends along the first direction and intersects with the at least two first bonding strips having the strip-shaped structure. In this way, the electrical connector is connected to the first connection portion through the first bonding layer. Through the foregoing arrangement, a height of the first bonding strips can be reduced, so that the height of the first bonding strips is relatively small, and the electrical connector is not held up by the first bonding strips. In this way, a risk of an offset of the electrical connector is reduced, and reliability of the connection between the electrical connector and the first connection portion is improved, thereby ensuring photoelectric conversion efficiency of the photovoltaic module and a soldering yield of the photovoltaic module. Further, through the foregoing arrangement, reliability of a connection between the second connection portion adjacent to the first connection portion and the electrical connector can also be improved, thereby further improving the photoelectric conversion efficiency of the photovoltaic module and the soldering yield of the photovoltaic module. In addition, the electrical connector extends along the first direction and intersects with or is perpendicular to each of the at least two first bonding strips having the strip-shaped structure. The electrical connector is connected to the first connection portion through the first bonding layer, so that a contact area between the electrical connector and the first connection portion can be increased, thereby improving the reliability of the connection between the electrical connector and the first connection portion.

In an embodiment, along the first direction, the first connection portion is located at positions close to an edge of the solar cell body. Compared with the first connection portion, the second connection portion is located at positions relatively away from the edge of the solar cell body.

In this embodiment of the present application, the first connection portion is located at the positions close to the edge of the solar cell body. Compared with the first connection portion, the second connection portion is located at the positions relatively away from the edge of the solar cell body. In this way, the electrical connector is connected to an edge region of the solar cell body through the first connection portion, thereby improving reliability of the connection between the electrical connector and the edge region of the solar cell body, and avoiding the offset of the electrical connector that causes a poor photovoltaic module. Further, the area of the first connection portion is relatively large, so that a process window of printing the first bonding layer can be broadened, thereby improving a fault tolerance rate that the first bonding layer is printed outside of the first connection portion. In addition, the first connection portion is used as a marking point in a process of printing the first bonding layer. The first connection portion has a relatively large size, so that a regular and square marking point can be provided for a capture camera, thereby further improving a printing yield of the first bonding layer.

In an embodiment, along the second direction, a width of the first connection portion is equal to a width of the second connection portion. Along the first direction, a length of the first connection portion is larger than a length of the second connection portion.

Through the foregoing arrangement, the area of the first connection portion is larger than the area of the second connection portion. The electrical connector is connected to an edge region of the solar cell body through the first connection portion, thereby improving reliability of the connection between the electrical connector and the edge region of the solar cell body, and avoiding the offset of the electrical connector that causes a poor photovoltaic module. Further, the area of the first connection portion is relatively large, so that a process window of printing the first bonding layer can be broadened, thereby improving a fault tolerance rate that the first bonding layer is printed outside of the first connection portion. In addition, the first connection portion is used as a marking point in a process of printing the first bonding layer. The first connection portion has a large size, so that a regular and square marking point can be provided for a capture camera, thereby improving a printing yield of the first bonding layer.

In an embodiment, the photovoltaic module further includes a second bonding layer. The second bonding layer is arranged on a surface of the second connection portion away from the solar cell body. The second bonding layer includes one second bonding strip having the strip-shaped structure. The second bonding strip extends along the second direction and intersects with the electrical connector. The electrical connector is electrically connected to the second connection portion through the second bonding layer. Through the foregoing arrangement, a height of the second bonding strip is close to the height of the first bonding strips, so that the electrical connector is not held up by the first bonding strips or the second bonding strip, to help improve the reliability of the connection between the electrical connector and the first connection portion and the second connection portion, thereby ensuring the photoelectric conversion efficiency of the photovoltaic module.

In an embodiment, a size of the second bonding strip is the same as a size of the first bonding strips. Through the foregoing arrangement, the height of the second bonding strip is closer to the height of the first bonding strips, so that the electrical connector is not held up by the first bonding strips or the second bonding strip, to further help improve the reliability of the connection between the electrical connector and the first connection portion and the second connection portion, thereby ensuring the photoelectric conversion efficiency of the photovoltaic module.

In an embodiment, the at least two first bonding strips are spaced apart from each other on the first connection portion; or bottoms of the at least two first bonding strips are connected to each other on the first connection portion. Through the foregoing arrangement, the first bonding layer reliably connects the electrical connector to the first connection portion, thereby ensuring the photoelectric conversion efficiency of the photovoltaic module.

In an embodiment, the first bonding strips extend along the second direction and have the rectangle-like structure; and/or the first bonding strips extend along the second direction and have a racetrack structure.

In this embodiment of the present application, the first bonding strips are arranged to have the rectangle-like structure extending along the second direction, and/or the first bonding strips are arranged to have the racetrack structure extending along the second direction, to improve consistency of heights of the first bonding strips, improve printing uniformity of the first bonding strips, and prevent the electrical connector from being held up by the first bonding strips. In this way, a probability of the offset of the electrical connector is further reduced, and the soldering yield of the photovoltaic module is improved.

Further, in a process of processing the photovoltaic module, metal paste needs to be printed on the surface of the first connection portion away from the solar cell body through screen printing process, to form the first bonding strips. During the screen printing process, if the first bonding strips have a rectangular structure, the metal paste easily remains at corner positions of a screen printing stencil, causing poor printing. However, circular corners having the rectangle-like structure or the racetrack structure can improve demould performance of the first bonding strips, so that the heights of the first bonding strips are uniform.

In addition, the first bonding strips having the rectangle-like structure or the racetrack structure are not easily printed outside of the first connection portion during the screen printing process, thereby avoiding a risk of a short circuit on the photovoltaic module, and improving a yield of the photovoltaic module.

In an embodiment, the first bonding strips have a polygonal structure. A quantity of edges of the polygonal structure is 4N. N satisfies N≥2. In a process of soldering the electrical connector to the first connection portion, the first bonding strips are briefly fused and are pressed by an ejector pin. Therefore, there is a risk that the first bonding strips and the electrical connector are pressed to deviate from the first connection portion. Compared with corner positions of the first bonding strips having a quadrangular structure like the rectangular structure or a square structure, the corner positions of the first bonding strips having the polygonal structure is farther away from edge positions of the first connection portion, In this way, a fault tolerance rate of deviation of the first bonding strips from the first connection portion can be improved, thereby reducing a probability of a risk of a short circuit on the photovoltaic module, and improving the yield of the photovoltaic module.

In an embodiment, the first bonding layer further includes a third bonding strip. The third bonding strip extends along the first direction. The third bonding strip is located on a central axis of the first connection portion. The electrical connector covers the third bonding strip. The electrical connector extends along the first direction. The third bonding strip is located between the electrical connector and the first connection portion. The electrical connector covers the third bonding strip. Through the third bonding strip, the reliability of the connection between the electrical connector and the first connection portion can be further improved, thereby improving the photoelectric conversion efficiency of the photovoltaic module.

In an embodiment, the first bonding layer has at least one of a 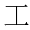 -shaped structure, a 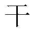 -shaped structure, a 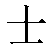 -shaped structure, and a 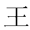 -shaped structure. In this embodiment of the present application, the first bonding layer is set to have at least one of the 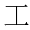 -shaped structure, the T-shaped structure, the 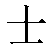 -shaped structure, and the 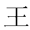 -shaped structure, to further improve the reliability of the connection between the electrical connector and the first connection portion, thereby ensuring the photoelectric conversion efficiency of the photovoltaic module.

In an embodiment, along the first direction, a width of the first bonding strips is smaller than a width of the second connection portion; and/or along the second direction, a length of the first bonding strips is smaller than a length of the second connection portion. Through the foregoing arrangement, an area of the first bonding strips can be controlled, so that the at least two first bonding strips can be arranged on the first connection portion, to reduce a height of the first bonding layer, prevent the electrical connector from being held up by the first bonding layer, and reduce a risk of the offset of the electrical connector, thereby improving the yield of the photovoltaic module.

In an embodiment, the first surface is a back surface of the solar cell body. In other words, the photovoltaic module in this embodiment of the present application is a back-contact photovoltaic module. The back-contact photovoltaic module has an advantage of high photoelectric conversion efficiency.

According to a second aspect, the present application discloses manufacturing methods of a photovoltaic module. The method includes the following steps: providing a solar cell body, where the solar cell body includes a first surface and a second surface arranged opposite to each other; forming a connection portion on the first surface of the solar cell body through screen printing process, where the connection portion includes a first connection portion and a second connection portion, the first connection portion and the second connection portion are arranged at intervals along a first direction, and an area of the first connection portion is larger than an area of the second connection portion; forming a first bonding layer on a surface of the first connection portion away from the solar cell body through screen printing process, where a squeegee moves along a second direction during the screen printing process, the first bonding layer includes at least two first bonding strips having a strip-shaped structure, the at least two first bonding strips extend along the second direction and are spaced apart from each other along the first direction, and the second direction intersects with the first direction; and providing an electrical connector, where the electrical connector is arranged on the first bonding layer, and the electrical connector extend along the first direction and intersect with the at least two first bonding strips having the strip-shaped structure, to be electrically connected to the first connection portion through the first bonding layer.

In an embodiment, before the providing an electrical connector, where the electrical connector is arranged on the first bonding layer, and the electrical connector extend along the first direction and intersect with the at least two first bonding layers having the strip-shaped structure, to be electrically connected to the first connection portion through the first bonding layer, the method further includes: forming a second bonding layer on a surface of the second connection portion away from the solar cell body through the screen printing process, where the squeegee moves along the second direction during the screen printing process, the second bonding layer includes one second bonding strip having the strip-shaped structure, the second bonding strip extends along the second direction and intersects with the electrical connector, and the electrical connector is electrically connected to the second connection portion through the second bonding layer.

In an embodiment, the forming a first bonding layer on a surface of the first connection portion away from the solar cell body through the screen printing process, where a squeegee moves along a second direction during the screen printing process, the first bonding layer includes at least two first bonding strips having a strip-shaped structure, the at least two first bonding strips extend along the second direction and are spaced apart from each other along the first direction, and the second direction intersects with the first direction further includes: forming the first bonding layer on the surface of the first connection portion away from the solar cell body through the screen printing process, where the squeegee moves along the second direction during the screen printing process, the first bonding layer includes the at least two first bonding strips having the strip-shaped structure and a third bonding strip, the at least two first bonding strips extend along the second direction and are spaced apart from each other along the first direction, the third bonding strip extending along the first direction, and the third bonding strip being located on a central axis of the first connection portion.

According to a third aspect, the present application discloses a screen printing stencil. The screen printing stencil includes a plurality of meshes holes. The plurality of meshes holes include at least two first meshes holes and a plurality of second meshes holes that are arranged at intervals along a first direction. The at least two first mesh holes are configured to form first bonding strips. The plurality of second mesh holes are configured to form a second bonding strip. A distance between two adjacent first meshes holes is less than a distance between two adjacent second meshes holes.

The present application discloses a photovoltaic module, manufacturing methods thereof, and screen printing stencils. The photovoltaic module includes a solar cell body, a connection portion, a first bonding layer, and an electrical connector. The solar cell body includes a first surface and a second surface arranged opposite to each other. The connection portion is arranged on the first surface. The connection portion includes a first connection portion and a second connection portion. The first connection portion and the second connection portion are arranged at intervals along a first direction. An area of the first connection portion is larger than an area of the second connection portion. The first bonding layer is arranged on a surface of the first connection portion away from the solar cell body. The first bonding layer includes at least two first bonding strips having a strip-shaped structure. The at least two first bonding strips extend along a second direction and are spaced apart from each other along the first direction. The second direction intersects with the first direction. The electrical connector is arranged on the first bonding layer. The electrical connector extends along the first direction and intersects with the at least two first bonding strips having the strip-shaped structure. The electrical connector is electrically connected to the first connection portion through the first bonding layer.

In the present application, the first bonding layer is arranged on the surface of the first connection portion away from the solar cell body, the first bonding layer includes the at least two first bonding strips having the strip-shaped structure, and the at least two first bonding strips extend along the second direction and are spaced apart from each other along the first direction. The electrical connector is arranged on the first bonding layer, and the electrical connector extends along the first direction and intersects with the at least two first bonding strips having the strip-shaped structure. In this way, the electrical connector is connected to the first connection portion through the first bonding layer. Through the foregoing arrangement, a height of the first bonding strips is relatively small, and the electrical connector is not held up by the first bonding strips. In this way, a probability of an offset of the electrical connector is reduced, and reliability of the connection between the electrical connector and the first connection portion is improved, thereby ensuring photoelectric conversion efficiency of the photovoltaic module.

Further, through the foregoing arrangement, reliability of a connection between the second connection portion adjacent to the first connection portion and the electrical connector can also be improved, thereby helping improve the yield of the photovoltaic module, and ensuring the photoelectric conversion efficiency of the photovoltaic module.

In addition, the electrical connector extends along the first direction and intersects with the at least two first bonding strips having the strip-shaped structure. The electrical connector is connected to the first connection portion through the first bonding layer, so that a contact area between the electrical connector and the first bonding layer can be increased, thereby improving the reliability of the connection between the electrical connector and the first connection portion.

### BRIEF DESCRIPTION OF THE DRAWINGS

FIG. 1 is a schematic structural diagram of a photovoltaic module according to an embodiment of the present application;
FIG. 2 is a first schematic diagram of a partial structure of a photovoltaic module according to an embodiment of the present application;
FIG. 3 is a second schematic diagram of a partial structure of a photovoltaic module according to an embodiment of the present application;
FIG. 4 is a schematic structural diagram of a pad according to an embodiment of the present application;
FIG. 5 is a first schematic structural diagram of a screen printing stencil according to an embodiment of the present application;
FIG. 6 is a second schematic structural diagram of a screen printing stencil according to an embodiment of the present application;
FIG. 7 is a third schematic structural diagram of a screen printing stencil according to an embodiment of the present application;
FIG. 8 is a schematic structural diagram of first mesh holes in a screen printing stencil according to an embodiment of the present application;
FIG. 9 is another schematic structural diagram of first mesh holes in a screen printing stencil according to an embodiment of the present application;
FIG. 10 is a first flowchart of manufacturing a photovoltaic module according to an embodiment of the present application; and
FIG. 11 is a second flowchart of manufacturing a photovoltaic module according to an embodiment of the present application.

### Reference numerals:

10: solar cell body;
20: connection portion; 21: first connection portion; 22: second connection portion;
30: first bonding layer; 31: first bonding strip; 32: third bonding strip;
40: second bonding strip;
50: first finger; 51: second finger;
60: screen printing stencil; 61: first mesh; 62: second mesh;
70: electrical connector;
A: first direction; and B: second direction.

### DETAILED DESCRIPTION

The following clearly and completely describes the technical solutions in the embodiments of the present application with reference to the accompanying drawings in the embodiments of the present application. Apparently, the described embodiments are some of the embodiments of the present application rather than all of the embodiments. All other embodiments obtained by a person of ordinary skill in the art based on the embodiments of the present application without creative efforts shall fall within the fixed scope of the present application.

It should be understood that "one embodiment" or "an embodiment" mentioned throughout this specification means that specific features, structures, or characteristics related to the embodiment are included in at least one embodiment of the present application. Therefore, "in one embodiment" or "in an embodiment" appearing throughout this specification is not necessarily a same embodiment. In addition, the specific features, structures, or characteristics may be combined in one or more embodiments in any suitable manner.

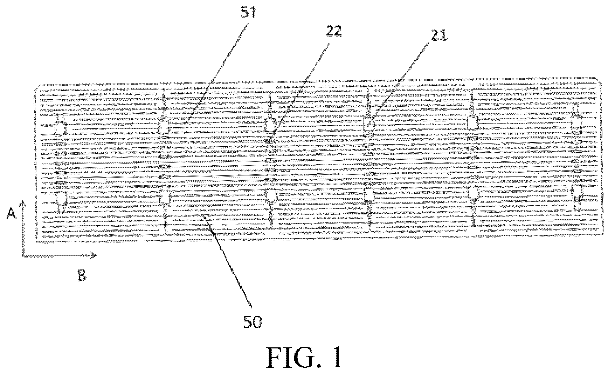

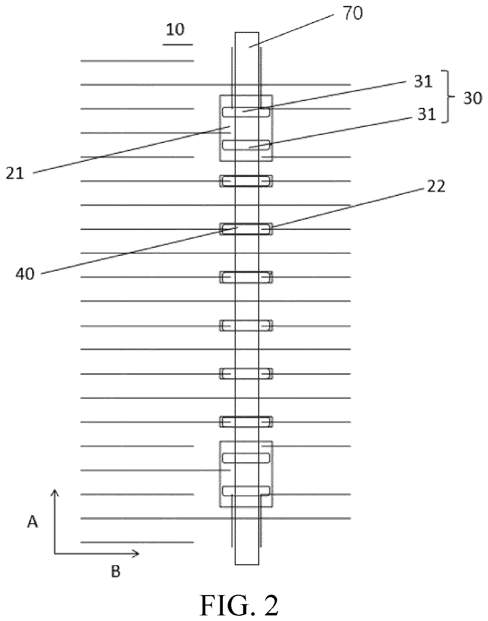

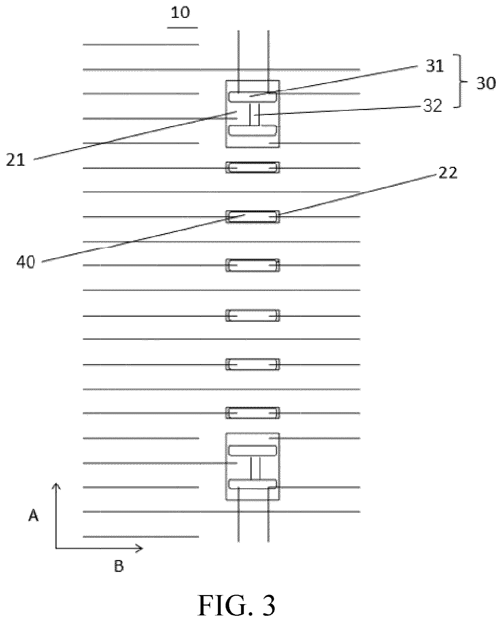

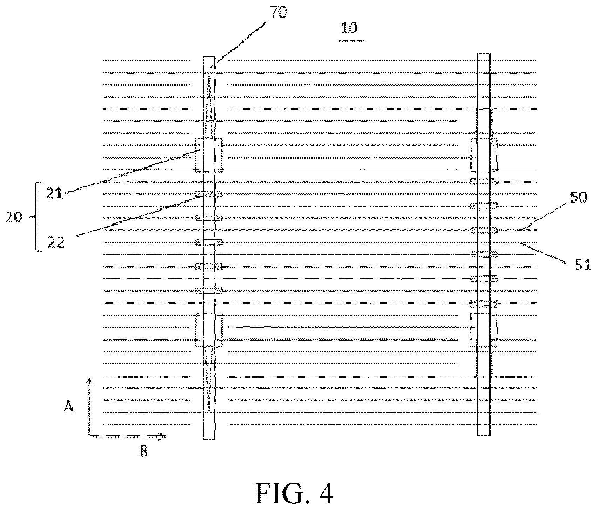

FIG. 1 is a schematic structural diagram of a photovoltaic module according to an embodiment of the present application. FIG. 2 is a first schematic diagram of a partial structure of a photovoltaic module according to an embodiment of the present application. FIG. 3 is a second schematic diagram of a partial structure of a photovoltaic module according to an embodiment of the present application. FIG. 4 is a schematic structural diagram of a pad according to an embodiment of the present application.

As shown in FIG. 1 to FIG. 4, an embodiment of the present application discloses a photovoltaic module. The photovoltaic module includes a solar cell body 10, a connection portion 20, a first bonding layer 30, and an electrical connector 70. The solar cell body 10 includes a first surface and a second surface arranged opposite to each other. The connection portion 20 is arranged on the first surface. The connection portion 20 includes a first connection portion 21 and a second connection portion 22. The first connection portion 21 and the second connection portion 22 are arranged at intervals along a first direction A. An area of the first connection portion 21 is larger than an area of the second connection portion 22. The first bonding layer 30 is arranged on a surface of the first connection portion 21 away from the solar cell body 10. The first bonding layer 30 includes at least two first bonding strips 31 having a strip-shaped structure. The at least two first bonding strips 31 extend along a second direction B and are arranged at an interval along the first direction A. The second direction B intersects with the first direction A. The electrical connector 70 is arranged on the first bonding layer 30. The electrical connector 70 extends along the first direction A and intersects with the at least two first bonding strips 31 having the strip-shaped structure. The electrical connector 70 is electrically connected to the first connection portion 21 through the first bonding layer 30.

The photovoltaic module disclosed in this embodiment of the present application includes the solar cell body 10. The solar cell body 10 is a core component of the photovoltaic module, which converts solar energy into electric energy. The solar cell body 10 has the first surface and the second surface arranged opposite to each other. When the first surface is a light-receiving surface facing sunlight, the second surface is a back surface facing away from the sunlight. When the first surface is the back surface facing away from the sunlight, the second surface is the light-receiving surface facing the sunlight.

The present application is described below by using an example in which the first surface of the solar cell body 10 is the back surface facing away from the sunlight, and the second surface of the solar cell body 10 is the light-receiving surface facing the sunlight. In other words, the solar cell disclosed in this embodiment of the present application is a back-contact solar cell.

As shown in FIG. 1 to FIG. 4, the photovoltaic module disclosed in this embodiment of the present application further includes the connection portion 20. The connection portion 20 is arranged on the first surface of the solar cell body 10. The connection portion 20 includes the first connection portion 21 and the second connection portion 22. The first connection portion 21 and the second connection portion 22 are arranged on the first surface of the solar cell body 10 at intervals along the first direction A. The area of the first connection portion 21 is larger than the area of the second connection portion 22.

For example, the first connection portion 21 and the second connection portion 22 have rectangular structures. Along the second direction B, a length of the first connection portion 21 is approximately equal to a length of the second connection portion 22. Along the first direction A, a width of the first connection portion 21 is larger than a width of the second connection portion 22.

For another example, the first connection portion 21 and the second connection portion 22 have rectangle-like structures. Along the second direction B, the length of the first connection portion 21 is approximately equal to the length of the second connection portion 22. Along the first direction A, the width of the first connection portion 21 is larger than the width of the second connection portion 22. The rectangle-like structure is a rectangular structure provided with chamfers. The chamfers are circular chamfers, or are square chamfers.

Certainly, the foregoing is merely an example of specific structures of the first connection portion 21 and the second connection portion 22. This is not used as a limitation to the present application. In an actual application, a technician alternatively sets the specific structures of the first connection portion 21 and the second connection portion 22 according to a requirement.

As shown in FIG. 1 to FIG. 4, the first bonding layer 30 is arranged on the surface of the first connection portion 21 away from the solar cell body 10, to improve reliability of the connection between the electrical connector 70 and the first connection portion 21 through the first bonding layer 30. Specifically, the first bonding layer 30 includes the at least two first bonding strips 31 having the strip-shaped structure. The at least two first bonding strips 31 are spaced apart from each other along the first direction A. A length direction of each of the first bonding strips 31 extends along the second direction B.

For example, in this embodiment of the present application, there are two, three, four, or five first bonding strips 31. In this embodiment of the present application, a specific quantity of arranged first bonding strips 31 is not excessively limited. In an actual application, the technician sets the specific quantity of first bonding strips 31 according to a requirement.

In this embodiment of the present application, the second direction B intersects with the first direction A. In an embodiment, the second direction B is perpendicular to the first direction A. For example, in this embodiment of the present application, when the solar cell body 10 has a rectangular structure, the first direction A is a width direction of the solar cell body 10, or is a length direction of the solar cell body 10. When the first direction A is the width direction of the solar cell body 10, the second direction B is the length direction of the solar cell body 10. When the first direction A is the length direction of the solar cell body 10, the second direction B is the width direction of the solar cell body 10.

It should be noted that in this embodiment of the present application, the first bonding layer 30 is a tin layer, or is another metal layer having electrical conduction. In this embodiment of the present application, a specific material of the first bonding layer 30 is not excessively limited. In an actual application, the technician sets the specific material of the first bonding layer 30 according to a requirement. The following describes the present application by using an example in which the first bonding layer 30 is the tin layer.

In a process of processing the photovoltaic module, a conductive connection material like tin paste is coated to the surface of the first connection portion 21 away from the solar cell body 10 through screen printing process, to form the first bonding layer 30, namely, the tin layer, on the surface of the first connection portion 21 away from the solar cell body 10, to improve the reliability of the connection between the electrical connector and the first connection portion 21 through the tin layer. During the screen printing process, a squeegee moves along the second direction B, so that the moving direction of the squeegee is the same as the extension direction of the first bonding strips 31.

The photovoltaic module disclosed in this embodiment of the present application further includes the electrical connector 70. The electrical connector 70 is arranged on the first bonding layer 30. The electrical connector 70 extends along the first direction A and intersects with the at least two first bonding strips 31 having the strip-shaped structure. In this way, the electrical connector 70 is connected to the first connection portion 21 through the first bonding layer 30.

In this embodiment of the present application, the electrical connector 70 extends along the first direction A. The electrical connector 70 is arranged on a side of the first bonding layer 30 away from the first connection portion 21. The electrical connector 70 intersects with the at least two first bonding strips 31 having the strip-shaped structure. In this way, the electrical connector 70 is connected to the first connection portion 21 through the first bonding layer 30. In other words, the electrical connector 70 extends along the first direction A, the first bonding strips 31 have the strip-shaped structure, and the length direction of the first bonding strips 31 extends along the second direction B. In this way, the extension direction of the electrical connector 70 intersects with the extension direction of the first bonding strips 31, to increase a contact area between the electrical connector 70 and the first bonding strips 31, thereby making the connection between the electrical connector 70 and the first connection portion 30 reliable.

It should be noted that in this embodiment of the present application, the electrical connector 70 only includes a metal bar body, or the electrical connector 70 includes the metal bar body and a metal layer wrapping a surface of the metal bar body. In this embodiment of the present application, a specific structure of the electrical connector 70 is not excessively limited. In an actual application, the technician performs a setting according to a requirement.

In this embodiment of the present application, the first bonding layer 30 is arranged on the surface of the first connection portion 21 away from the solar cell body 10, the first bonding layer 30 includes the at least two first bonding strips 31, the at least two first bonding strips 31 are arranged at an interval along the first direction A, and the first bonding strips 31 have the strip-shaped structure extending along the second direction B. The electrical connector 70 is arranged on the first bonding layer 30, and the electrical connector 70 extends along the first direction A and intersects with the at least two first bonding strips 31 having the strip-shaped structure. In this way, the electrical connector 70 is connected to the first connection portion 21 through the first bonding layer 30. Through the foregoing arrangement, a height of the first bonding strips 31 can be reduced, so that the height of the first bonding strips 31 is relatively small, and the electrical connector 70 is not held up by the first bonding strips 31. In this way, a risk of an offset of the electrical connector 70 is reduced, and the reliability of the connection between the electrical connector 70 and the first connection portion 21 is improved, thereby ensuring photoelectric conversion efficiency of the photovoltaic module and a soldering yield of the photovoltaic module.

Further, through the foregoing arrangement, reliability of a connection between the second connection portion 22 adjacent to the first connection portion 21 and the electrical connector 70 can also be improved, thereby further improving the photoelectric conversion efficiency of the photovoltaic module and the soldering yield of the photovoltaic module.

In addition, the electrical connector 70 extends along the first direction A and intersects with the at least two first bonding strips 31 having the strip-shaped structure. The electrical connector 70 is connected to the first connection portion 21 through the first bonding layer 30, so that a contact area between the electrical connector 70 and the first bonding layer 30 can be increased, thereby improving the reliability of the connection between the electrical connector 70 and the first connection portion 21.

In an embodiment, as shown in FIG. 1 to FIG. 4, along the first direction A, the first connection portion 21 is located at positions close to an edge of the solar cell body 10. Compared with the first connection portion 21, the second connection portion 22 is located at positions relatively away from the edge of the solar cell body 10.

As shown in FIG. 1 to FIG. 4, along the first direction A, the solar cell body 10 has a first side edge and a second side edge arranged opposite to each other. The first connection portion 21 is located in a region of the solar cell body 10 close to the first side edge or the second side edge. Compared with the first connection portion 21, the second connection portion 22 is located in a region relatively away from the first side edge and the second side edge of the solar cell body 10.

It should be noted that in this embodiment of the present application, the first connection portion 21 and the second connection portion 22 generally have the rectangular structures, and the area of the first connection portion 21 is larger than the area of the second connection portion 22. The first connection portion 21 is located at the positions close to the edge of the solar cell body 10. Compared with the first connection portion 21, the second connection portion 22 is located at the positions relatively away from the edge of the solar cell body 10. In this way, the electrical connector 70 is connected to an edge region of the solar cell body 10 through the first connection portion 21, thereby improving reliability of the connection between the electrical connector 70 and the edge region of the solar cell body 10, and avoiding the offset of the electrical connector 70 that causes a poor photovoltaic module.

Further, the area of the first connection portion 21 is relatively large, so that a process window of printing the first bonding layer 30 can be broadened, thereby improving a fault tolerance rate that the first bonding layer 30 is printed outside of the first connection portion 21.

In addition, the first connection portion 21 is used as a marking point in a process of printing the first bonding layer 30. The first connection portion 21 has a relatively large size, so that a regular and square marking point can be provided for a capture camera, thereby further improving a printing yield of the first bonding layer 30.

In an embodiment, as shown in FIG. 1 to FIG. 4, along the second direction B, the width of the first connection portion 21 is approximately equal to the width of the second connection portion 22. Along the first direction A, the length of the first connection portion 21 is larger than the length of the second connection portion 22.

As shown in FIG. 1 to FIG. 4, in this embodiment of the present application, the first connection portion 21 and the second connection portion 22 have the rectangular structures, and the first connection portion 21 and the second connection portion 22 having the rectangular structures are arranged at intervals along the first direction A. Along the second direction B, the width of the first connection portion 21 is approximately equal to the width of the second connection portion 22. In addition, along the first direction A, the length of the first connection portion 21 is larger than the length of the second connection portion 22. In this way, the area of the first connection portion 21 is larger than the area of the second connection portion 22. The electrical connector 70 is connected to an edge region of the solar cell body 10 through the first connection portion 21, thereby improving reliability of the connection between the electrical connector 70 and the edge region of the solar cell body 10, and avoiding the offset of the electrical connector 70 that causes a poor photovoltaic module.

Further, the area of the first connection portion 21 is relatively large, so that a process window of printing the first bonding layer 30 can be broadened, thereby improving a fault tolerance rate that the first bonding layer 30 is printed outside of the first connection portion 21. In addition, the first connection portion 21 is used as a marking point in a process of printing the first bonding layer 30. The first connection portion 21 has a relatively large size, so that a regular and square marking point can be provided for a capture camera, thereby improving a printing yield of the first bonding layer 30.

In an embodiment, as shown in FIG. 1 to FIG. 4, in this embodiment of the present application, the photovoltaic module further includes a second bonding layer. The second bonding layer is arranged on a surface of the second connection portion 22 away from the solar cell body 10. The second bonding layer includes one second bonding strip 40 having a strip-shaped structure, the second bonding strip 40 extends along the second direction B, the second bonding strip 40 intersects with the electrical connector 70. The electrical connector 70 is electrically connected to the second connection portion 22 through the second bonding layer.

As shown in FIG. 1 to FIG. 4, in this embodiment of the present application, the second bonding layer is arranged on the surface of the second connection portion 22 away from the solar cell body 10, and the electrical connector 70 is connected to the second connection portion 22 through the second bonding layer, to improve reliability of the connection between the electrical connector 70 and the second connection portion 22.

The second bonding layer includes the one second bonding strip 40 having the strip-shaped structure. The second bonding strip 40 extends along the second direction B. Through the foregoing arrangement, a height of the second bonding strip 40 is close to the height of the first bonding strips 31, so that the electrical connector 70 is not held up by the first bonding strips 31 or the second bonding strip 40, to help improve the reliability of the connection between the electrical connector 70 and the first connection portion 21 and the second connection portion 22, thereby ensuring the photoelectric conversion efficiency of the photovoltaic module.

In an embodiment, as shown in FIG. 1 to FIG. 4, in this embodiment of the present application, a size of the second bonding strip 40 is the same as the size of the first bonding strips 31.

As shown in FIG. 1 to FIG. 4, in this embodiment of the present application, the size of the second bonding strip 40 is the same as the size of the first bonding strips 31. For example, when the first bonding strips 31 have a rectangle-like structure, the second bonding strip 40 also has the rectangle-like structure, and the length and the width of the first bonding strips 31 are respectively approximately equal to a length and a width of the second bonding strip 40. Through the foregoing arrangement, the height of the second bonding strip 40 is closer to the height of the first bonding strips 31, so that the electrical connector 70 is not held up by the first bonding strips 31 or the second bonding strip 40, to further help improve the reliability of the connection between the electrical connector 70 and the first connection portion 21 and the second connection portion 22, thereby ensuring the photoelectric conversion efficiency of the photovoltaic module.

It should be noted that in this embodiment of the present application, the rectangle-like structure is a rectangular structure provided with chamfers arranged at four corners. The chamfers are square chamfers, or are circular chamfers.

In an embodiment, the at least two first bonding strips 31 are spaced apart from each other on the first connection portion 21; or bottoms of the at least two first bonding strips 31 are connected to each other on the first connection portion 21.

In this embodiment of the present application, the first bonding layer 30 includes the at least two first bonding strips 31 spaced apart from each other along the first direction A, and the at least two first bonding strips 31 are spaced apart from each other on the first connection portion 21. In other words, each of the at least two first bonding strips 31 is connected to the electrical connector 70, and no other connection structure is arranged between the at least two first bonding strips 31.

Alternatively, the first bonding layer 30 includes the at least two first bonding strips 31 spaced apart from each other along the first direction A, and the bottoms of the at least two first bonding strips 31 are connected to each other on the first connection portion 21. For example, a bonding strip extending along the first direction A is arranged to connect the at least two first bonding strips 31. The bonding strip and the at least two first bonding strips 31 are connected to the electrical connector 70, to further improve the reliability of the connection between the first connection portion 21 and the electrical connector 70, thereby ensuring the photoelectric conversion efficiency of the photovoltaic module.

In an embodiment, as shown in FIG. 1 to FIG. 4, in this embodiment of the present application, the first bonding strips 31 extend along the second direction B and have the rectangle-like structure; and/or the first bonding strips 31 extend along the second direction B and have a racetrack structure.

As shown in FIG. 1 to FIG. 4, in this embodiment of the present application, the first bonding strips 31 are arranged to have the rectangle-like structure extending along the second direction B. The rectangle-like structure is a rectangle-like structure formed by arranging circular chamfers at the four corners having the rectangular structure; a rectangle-like structure formed by arranging square chamfers at the four corners having the rectangular structure; or a rectangle-like structure formed by arranging chamfers of another shape at the four corners having the rectangular structure. In this embodiment of the present application, a specific type of the chamfers arranged at the four corners having the rectangular structure are not excessively limited. In an actual application, the technician performs a setting according to a requirement.

In this embodiment of the present application, the first bonding strips 31 are arranged to have the racetrack structure extending along the second direction B. It may be understood that, the racetrack structure includes a rectangular structure extending along the second direction B and arc structures respectively connected to two ends having the rectangular structure.

In this embodiment of the present application, the first bonding strips 31 are arranged to have the rectangle-like structure extending along the second direction B, and/or the first bonding strips 31 are arranged to have the racetrack structure extending along the second direction B, to improve consistency of heights of the first bonding strips 31, improve printing uniformity of the first bonding strips 31, and prevent the electrical connector from being held up by the first bonding strips 31. In this way, a probability of the offset of the electrical connector is further reduced, and the soldering yield of the photovoltaic module is improved.

Further, in a process of processing the photovoltaic module, metal paste needs to be printed on the surface of the first connection portion 21 away from the solar cell body 10 through screen printing process, to form the first bonding strips 31. During the screen printing process, if the first bonding strips 31 have a rectangular structure, the metal paste easily remains at corner positions of a screen printing stencil, causing poor printing. However, circular corners having the rectangle-like structure or the racetrack structure can improve demould performance of the first bonding strips 31, so that the heights of the first bonding strips 31 are uniform.

In addition, the first bonding strips 31 having the rectangle-like structure or the racetrack structure are not easily printed outside of the first connection portion 21 during the screen printing process, thereby avoiding a risk of a short circuit on the photovoltaic module, and improving a yield of the photovoltaic module.

In an embodiment, as shown in FIG. 1 to FIG. 4, in this embodiment of the present application, the first bonding strips 31 have a polygonal structure. A quantity of edges of the polygonal structure is 4N. N satisfies N≥2.

As shown in FIG. 1 to FIG. 4, in this embodiment of the present application, the first bonding strips 31 are set to have the polygonal structure. The quantity of edges of the polygonal structure is 4N. N≥2. In a process of soldering the electrical connector to the first connection portion 21, the first bonding strips 31 are briefly fused and are pressed by an ejector pin. Therefore, there is a risk that the first bonding strips 31 and the electrical connector are pressed to deviate from the first connection portion 21. Compared with corner positions of the first bonding strips 31 having a quadrangular structure like the rectangular structure or a square structure, the corner positions of the first bonding strips 31 having the polygonal structure is farther away from edge positions of the first connection portion 21. In this way, a fault tolerance rate of deviation of the first bonding strips 31 from the first connection portion 21 can be improved, thereby reducing a probability of a risk of a short circuit on the photovoltaic module, and improving the yield of the photovoltaic module.

For example, when N=2, the first bonding strips 31 have an octagonal structure. When N=3, the first bonding strips 31 have a dodecagonal structure. When N=4, the first bonding strips 31 have a hexadecagonal structure. Certainly, the foregoing is merely an example of a specific structure of the first bonding strips 31 in this embodiment of the present application. This is not used as a limitation to the present application. In an actual application, the technician also sets a specific value of N according to an actual requirement, to determine the specific structure of the first bonding strips 31.

In an embodiment, as shown in FIG. 3, in this embodiment of the present application, the first bonding layer 30 further includes a third bonding strip 32. The third bonding strip 32 extends along the first direction A. The third bonding strip 32 is located on a central axis of the first connection portion 21. The electrical connector 70 covers the third bonding strip 32.

In this embodiment of the present application, the first bonding layer 30 further includes the third bonding strip 32. The third bonding strip 32 has a long strip-shaped structure extending along the first direction A. The third bonding strip 32 is located on the central axis of the first connection portion 21. The electrical connector 70 extends along the first direction A. The electrical connector 70 covers the third bonding strip 32. In other words, the third bonding strip 32 is located between the electrical connector 70 and the first connection portion 21. In this way, through the arrangement of the third bonding strip 32, the reliability of the connection between the electrical connector 70 and the first connection portion 21 can be further improved, thereby improving the photoelectric conversion efficiency of the photovoltaic module.

In an embodiment, the first bonding layer 30 has at least one of a 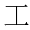 -shaped structure, a 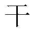 -shaped structure, a 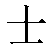 -shaped structure, and a 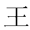 -shaped structure.

For example, when the first bonding layer 30 includes two first bonding strips 31, the two first bonding strips 31 extend along the second direction B and are arranged at an interval along the first direction A. The third bonding strip 32 extends along the first direction A and is connected to the two first bonding strips 31, to form the first bonding layer 30 having the 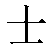 -shaped structure, form the first bonding layer 30 having the 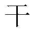 -shaped structure, or form the first bonding layer 30 having the 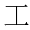 -shaped structure. Alternatively, when the first bonding layer 30 includes three first bonding strips 31, the three first bonding strips 31 extend along the second direction B and are arranged at intervals along the first direction A. The third bonding strip 32 and the three first bonding strips 31 form the first bonding layer 30 having the 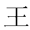 -shaped structure.

In this embodiment of the present application, the first bonding layer 30 is set to have at least one of the 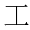 -shaped structure, the 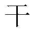 -shaped structure, the 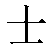 -shaped structure, and the 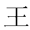 -shaped structure, to further improve the reliability of the connection between the electrical connector 70 and the first connection portion 21, thereby ensuring the photoelectric conversion efficiency of the photovoltaic module.

It should be noted that in this embodiment of the present application, the third bonding strip 32 is at least partially arranged between the electrical connector 70 and the first connection portion 21. To be specific, the third bonding strip 32 is at least partially located below the electrical connector 70, to improve the reliability of the connection between the first connection portion 21 and the electrical connector 70 through the third bonding strip 32.

In an embodiment, as shown in FIG. 1 to FIG. 4, along the first direction A, the width of the first bonding strips 31 is smaller than the width of the second connection portion 22; and/or along the second direction B, the length of the first bonding strips 31 is smaller than the length of the second connection portion 22.

As shown in FIG. 1 to FIG. 4, in this embodiment of the present application, along the first direction A, the width of the first bonding strips 31 is set to be smaller than the width of the second connection portion 22; and/or along the second direction B, the length of the first bonding strips 31 is set to be smaller than the length of the second connection portion 22. Through the foregoing arrangement, an area of the first bonding strips 31 can be controlled, so that the at least two first bonding strips 31 can be arranged on the first connection portion 21, to reduce a height of the first bonding layer 30, prevent the electrical connector 70 from being held up by the first bonding layer 30, and reduce a risk of the offset of the electrical connector 70, thereby improving the yield of the photovoltaic module.

In an embodiment, the first surface in this embodiment of the present application is a back surface of the solar cell body 10. In other words, the photovoltaic module in this embodiment of the present application is a back-contact photovoltaic module. The back-contact photovoltaic module has an advantage of high photoelectric conversion efficiency.

In an embodiment, a plurality of first fingers 50 and a plurality of second fingers 51 are arranged on the first surface of the solar cell body 10. The plurality of first fingers 50 and the plurality of second fingers 51 extend along the second direction B and are alternately arranged along the first direction A. The first finger 50 is connected to the connection portion 20. At least one second finger 51 is located between the first connection portion 21 and the second connection portion 22 adjacent to each other.

As shown in FIG. 1 to FIG. 4, in this embodiment of the present application, the plurality of first fingers 50 and the plurality of second fingers 51 are arranged on the first surface of the solar cell body 10. The plurality of first fingers 50 and the plurality of second fingers 51 extend along the second direction B and are alternately arranged along the first direction A. In this way, currents generated by the solar cell body 10 are collected through the plurality of first fingers 50 and the plurality of second fingers 51.

The first finger 50 is connected to the connection portion 20. A current collected by the first finger 50 is collected through the connection portion 20. To be specific, the first connection portion 21 is connected to at least one first finger 50, and the second connection portion 22 is also connected to at least one first finger 50. In this way, the current collected by the first finger 50 is collected through the first connection portion 21 and the second connection portion 22, the collected current is transmitted to the electrical connector, and the current is transmitted to an external circuit through the electrical connector.

As shown in FIG. 1 to FIG. 4, at least one second finger 51 is located between the first connection portion 21 and the second connection portion 22 adjacent to each other, to prevent the second finger 51 from being connected to the first connection portion 21 or the second connection portion 22, thereby avoiding a short circuit on the photovoltaic module.

In an embodiment, the electrical connector in this embodiment of the present application is in direct contact with the at least two first bonding strips 31.

In this embodiment of the present application, the electrical connector is in direct contact with the at least two first bonding strips 31, so that the electrical connector is connected to the first connection portion 21 through the at least two first bonding strips 31, thereby improving the reliability of the connection between the electrical connector and the first connection portion 21.

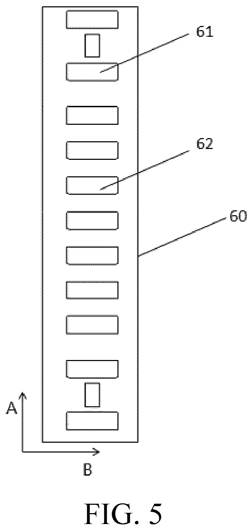

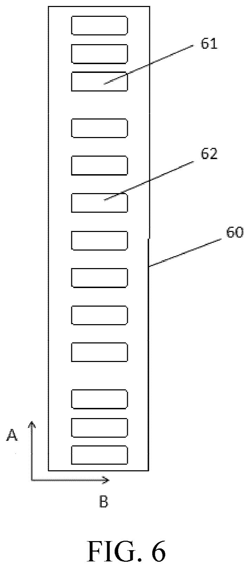

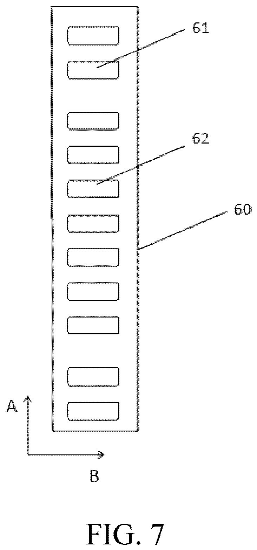

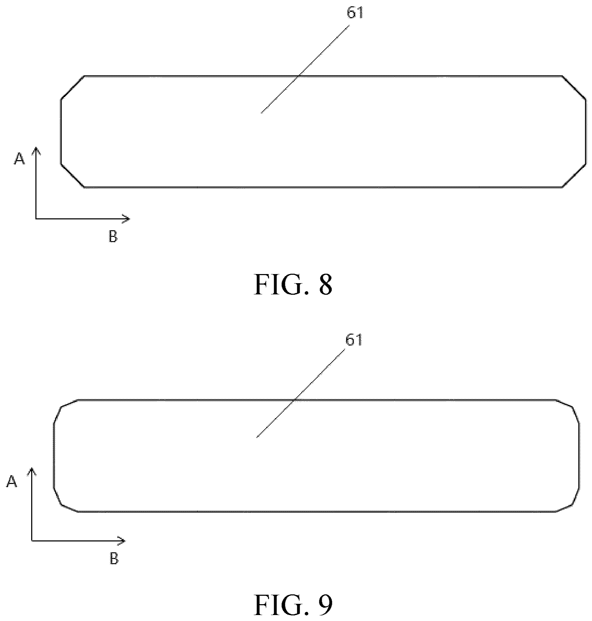

FIG. 5 is a first schematic structural diagram of a screen printing stencil according to an embodiment of the present application. FIG. 6 is a second schematic structural diagram of a screen printing stencil according to an embodiment of the present application. FIG. 7 is a third schematic structural diagram of a screen printing stencil according to an embodiment of the present application. FIG. 8 is a schematic structural diagram of first mesh holes in a screen printing stencil according to an embodiment of the present application. FIG. 9 is another schematic structural diagram of first mesh holes in a screen printing stencil according to an embodiment of the present application.

As shown in FIG. 5 to FIG. 9, an embodiment of the present application further discloses a screen printing stencil 60. The screen printing stencil 60 includes a plurality of meshes holes. The plurality of meshes holes include at least two first meshes holes 61 and a plurality of second meshes holes 62 that are arranged at intervals along a first direction A. The at least two first mesh holes are configured to form first bonding strips 31. The plurality of second mesh holes are configured to form a second bonding strip 40. A distance between two adjacent first meshes holes 61 is less than a distance between two adjacent second meshes holes 62.

An embodiment of the present application further discloses the screen printing stencil 60. Through the screen printing stencil 60 disclosed in this embodiment of the present application, metal paste is printed on a surface of a first connection portion 21 away from a solar cell body 10, to form at least two first bonding strips 31 on the surface of the first connection portion 21 away from the solar cell body 10, and is printed on a surface of a second connection portion 22 away from the solar cell body 10, to form one second bonding strip 40 on the surface of the second connection portion 22 away from the solar cell body 10. In this way, the metal paste is not prone to remain at corner positions of the screen printing stencil 60, so that a printing yield of a photovoltaic module is relatively high.

Further, through the screen printing stencil 60 disclosed in this embodiment of the present application, the metal paste is printed on the surface of the first connection portion 21 away from the solar cell body 10, to form the at least two first bonding strips 31 on the surface of the first connection portion 21 away from the solar cell body 10. The metal paste is printed on the surface of the second connection portion 22 away from the solar cell body 10, to form the one second bonding strip 40 on the surface of the second connection portion 22 away from the solar cell body 10. In this way, demould performance of the first bonding strips 31 and the second bonding strip 40 is better, a height of the first bonding strips 31 and a height of the second bonding strip 40 are more consistent, and the electrical connector is not held up by the first bonding strips 31. In this way, a risk of an offset of the electrical connector is reduced, and reliability of the connection between the electrical connector and the first connection portion 21 and the second connection portion 22 is improved, thereby ensuring photoelectric conversion efficiency of the photovoltaic module and a soldering yield of the photovoltaic module.

Further, the first bonding strips 31 are not prone to be printed outside of the first connection portion 21 during screen printing process.

It should be noted that in this embodiment of the present application, the distance between two adjacent first meshes holes 61 is less than the distance between two adjacent second meshes holes 62. In this way, the first bonding strips 31 formed by printing on the first mesh holes 61 are located on the first connection portion 21, and the second bonding strip 40 formed by printing on the second mesh holes 62 is located on the second connection portion 22.

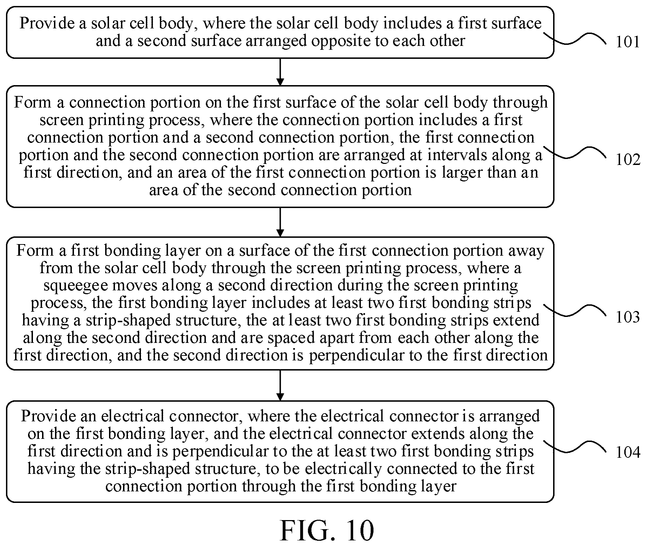

FIG. 10 is a first flowchart of manufacturing a photovoltaic module according to an embodiment of the present application.

An embodiment of the present application discloses a manufacturing method of a photovoltaic module. The method includes the following steps:
Step 101: Provide a solar cell body 10, where the solar cell body 10 includes a first surface and a second surface arranged opposite to each other.

The photovoltaic module disclosed in this embodiment of the present application includes the solar cell body 10. The solar cell body 10 is a core component of the photovoltaic module, which converts solar energy into electric energy. The solar cell body 10 has the first surface and the second surface arranged opposite to each other. When the first surface is a light-receiving surface facing the sunlight, the second surface is a back surface facing away from the sunlight. When the first surface is the back surface facing away from the sunlight, the second surface is the light-receiving surface facing the sunlight.

The present application is described below by using an example in which the first surface of the solar cell body 10 is the back surface facing away from the sunlight, and the second surface of the solar cell body 10 is the light-receiving surface facing the sunlight. In other words, the solar cell disclosed in this embodiment of the present application is a back-contact solar cell.

Step 102: Form a connection portion 20 on the first surface of the solar cell body 10 through screen printing process, where the connection portion 20 includes a first connection portion 21 and a second connection portion 22, the first connection portion 21 and the second connection portion 22 are arranged at intervals along a first direction A, and an area of the first connection portion 21 is larger than an area of the second connection portion 22.

In a process of manufacturing the photovoltaic module, the connection portion 20 is formed on the first surface of the solar cell body 10 through the screen printing process. The connection portion 20 includes the first connection portion 21 and the second connection portion 22. The first connection portion 21 and the second connection portion 22 are arranged on the first surface of the solar cell body 10 at intervals along the first direction A. The area of the first connection portion 21 is larger than the area of the second connection portion 22.

For example, the first connection portion 21 and the second connection portion 22 have rectangular structures. Along the second direction B, a length of the first connection portion 21 is approximately equal to a length of the second connection portion 22. Along the first direction A, a width of the first connection portion 21 is larger than a width of the second connection portion 22.

For another example, the first connection portion 21 and the second connection portion 22 have rectangle-like structures. Along the second direction B, the length of the first connection portion 21 is approximately equal to the length of the second connection portion. Along the first direction A, the width of the first connection portion is larger than the width of the second connection portion 22. The rectangle-like structure is a rectangular structure provided with chamfers. The chamfers are circular chamfers, or are square chamfers.

Certainly, the foregoing is merely an example of specific structures of the first connection portion 21 and the second connection portion 22. This is not used as a limitation to the present application. In an actual application, a technician alternatively sets the specific structures of the first connection portion 21 and the second connection portion 22 according to a requirement.

Step 103: Form a first bonding layer 30 on a surface of the first connection portion 21 away from the solar cell body 10 through the screen printing process, where a squeegee moves along a second direction B during the screen printing process, the first bonding layer 30 includes at least two first bonding strips 31 having a strip-shaped structure, the at least two first bonding strips 31 extend along the second direction B and are spaced apart from each other along the first direction A, and the second direction B intersects with the first direction A.

The first bonding layer 30 is formed on the surface of the first connection portion 21 away from the solar cell body 10 through the screen printing process, to improve reliability of a connection between electrical connector 70 and the first connection portion 21 through the first bonding layer 30. Specifically, the squeegee moves along the second direction B during the screen printing process. The first bonding layer 30 includes the at least two first bonding strips 31 having the strip-shaped structure. The at least two first bonding strips 31 are spaced apart from each other along the first direction A. A length direction of each of the first bonding strips 31 extends along the second direction B. In this way, the moving direction of the squeegee is consistent with the length direction of the first bonding strips 31.

For example, in this embodiment of the present application, there are two, three, four, or five first bonding strips 31. In this embodiment of the present application, a specific quantity of arranged first bonding strips 31 is not excessively limited. In an actual application, the technician sets the specific quantity of first bonding strips 31 according to a requirement.

In this embodiment of the present application, the second direction B intersects with the first direction A. In an embodiment, the second direction B is perpendicular to the first direction A. For example, in this embodiment of the present application, when the solar cell body 10 has a rectangular structure, the first direction A is a width direction of the solar cell body 10, or is a length direction of the solar cell body 10. When the first direction A is the width direction of the solar cell body 10, the second direction B is the length direction of the solar cell body 10. When the first direction A is the length direction of the solar cell body 10, the second direction B is the width direction of the solar cell body 10.

It should be noted that in this embodiment of the present application, the first bonding layer 30 is a tin layer, or is another metal layer having electrical conduction. In this embodiment of the present application, a specific material of the first bonding layer 30 is not excessively limited. In an actual application, the technician sets the specific material of the first bonding layer 30 according to a requirement. The following describes the present application by using an example in which the first bonding layer 30 is the tin layer.

In a process of processing the photovoltaic module, a conductive connection material like tin paste is coated to the surface of the first connection portion 21 away from the solar cell body 10 through the screen printing process, to form the first bonding layer 30, namely, the tin layer, on the surface of the first connection portion 21 away from the solar cell body 10, to improve the reliability of the connection between the electrical connector 70 and the first connection portion 21 through the tin layer.

Step 104: Provide an electrical connector 70, where the electrical connector 70 is arranged on the first bonding layer 30, and the electrical connector 70 extends along the first direction A and intersects with the at least two first bonding strips 31 having the strip-shaped structure, to be electrically connected to the first connection portion 21 through the first bonding layer 30.

In this embodiment of the present application, the electrical connector 70 extends along the first direction A. The electrical connector 70 is arranged on a side of the first bonding layer 30 away from the first connection portion 21. The electrical connector 70 intersects with the at least two first bonding strips 31 having the strip-shaped structure. In this way, the electrical connector 70 is connected to the first connection portion 21 through the first bonding layer 30. In other words, the electrical connector 70 extends along the first direction A, the first bonding strips 31 have the strip-shaped structure, and the first bonding strips 31 having the strip-shaped structure extend along the second direction B. In this way, the second bonding strips 31 intersect with the electrical connector 70, to increase a contact area between the electrical connector 70 and the first bonding strips 31, thereby making the connection between the electrical connector 70 and the first connection portion 21 reliable.

It should be noted that in this embodiment of the present application, the electrical connector 70 only includes a metal bar body, or the electrical connector 70 includes the metal bar body and a metal layer wrapping a surface of the metal bar body. In this embodiment of the present application, a specific structure of the electrical connector 70 is not excessively limited. In an actual application, the technician performs a setting according to a requirement.

In this embodiment of the present application, the first bonding layer 30 is arranged on the surface of the first connection portion 21 away from the solar cell body 10 through the screen printing process. The squeegee moves along the second direction B during the screen printing process. The first bonding layer 30 includes the at least two first bonding strips 31 having the strip-shaped structure. The at least two first bonding strips 31 extend along the second direction B and are spaced apart from each other along the first direction A. In other words, the moving direction of the squeegee is the same as the extension direction of the first bonding strips 31. The electrical connector 70 is arranged on the side of the first bonding layer 30 away from the first connection portion 21. The electrical connector 70 is connected to the first connection portion 21 through the first bonding layer 30. Through the foregoing arrangement, a height of the first bonding strips 31 can be reduced, so that the height of the first bonding strips 31 is relatively small, and the electrical connector 70 is not held up by the first bonding strips 31. In this way, a risk of an offset of the electrical connector 70 is reduced, and the reliability of the connection between the electrical connector 70 and the first connection portion 21 is improved, thereby ensuring photoelectric conversion efficiency of the photovoltaic module and a soldering yield of the photovoltaic module.

Further, through the foregoing arrangement, reliability of a connection between the second connection portion 22 adjacent to the first connection portion 21 and the electrical connector 70 can also be improved, thereby further improving the photoelectric conversion efficiency of the photovoltaic module and the soldering yield of the photovoltaic module.

In addition, the electrical connector 70 extends along the first direction A and intersects with the at least two first bonding strips 31 having the strip-shaped structure. The electrical connector 70 is connected to the first connection portion 21 through the first bonding layer 30, so that a contact area between the electrical connector 70 and the first bonding layer 30 can be increased, thereby improving the reliability of the connection between the electrical connector 70 and the first connection portion 21.

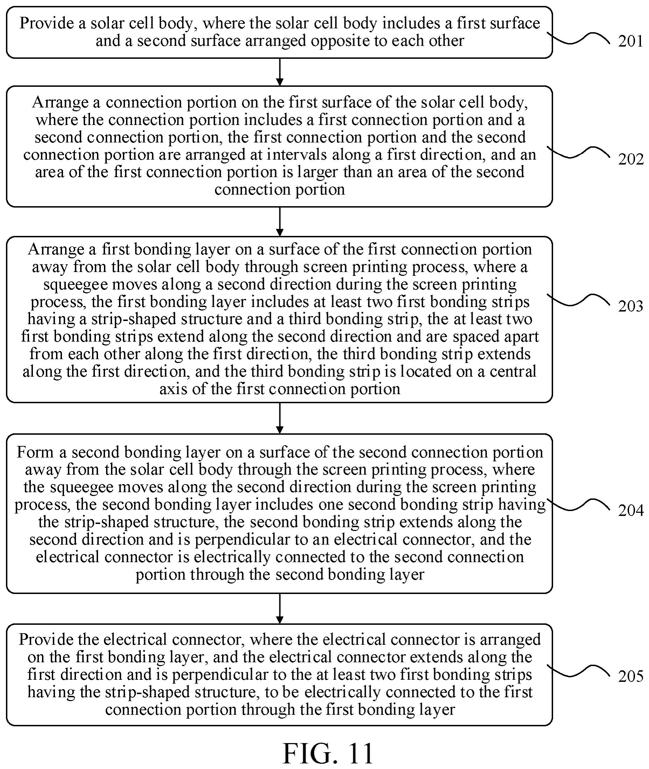

FIG. 11 is a second flowchart of manufacturing a photovoltaic module according to an embodiment of the present application.

Step 201: Provide a solar cell body 10, where the solar cell body 10 includes a first surface and a second surface arranged opposite to each other.

Step 201 in this embodiment of the present application is the same as step 101 in the foregoing embodiment. For related content, refer to the foregoing embodiment. Details are not described herein again.

Step 202: Form a connection portion 20 on the first surface of the solar cell body 10 through screen printing process, where the connection portion 20 includes a first connection portion 21 and a second connection portion 22, the first connection portion 21 and the second connection portion 22 are arranged at intervals along a first direction A, and an area of the first connection portion 21 is larger than an area of the second connection portion 22.

Step 202 in this embodiment of the present application is the same as step 102 in the foregoing embodiment. For related content, refer to the foregoing embodiment. Details are not described herein again.

Step 203: Arrange a first bonding layer 30 on a surface of the first connection portion 21 away from the solar cell body 10 through the screen printing process, where a squeegee moves along a second direction B during the screen printing process, the first bonding layer 30 includes at least two first bonding strips 31 having a strip-shaped structure and a third bonding strip 32, the at least two first bonding strips 31 extend along the second direction B and are spaced apart from each other along the first direction A, the third bonding strip 32 extends along the first direction A, and the third bonding strip 32 is located on a central axis of the first connection portion 21.

The first bonding layer 30 is formed on the surface of the first connection portion 21 away from the solar cell body 10 through the screen printing process, to improve reliability of a connection between an electrical connector 70 and the first connection portion 21 through the first bonding layer 30. Specifically, the first bonding layer 30 includes the at least two first bonding strips 31 having the strip-shaped structure and the third bonding strip 32. The at least two first bonding strips 31 extend along the second direction B and are spaced apart from each other along the first direction A. The squeegee moves along the second direction B during the screen printing process, so that the moving direction of the squeegee is the same as the length direction of the first bonding strips 31. The third bonding strip 32 extends along the first direction A. The third bonding strip 32 is located on the central axis of the first connection portion 21.

In other words, in this embodiment of the present application, the first bonding layer 30 further includes the third bonding strip 32. The third bonding strip 32 has a long strip-shaped structure extending along the first direction A. The third bonding strip 32 is located on the central axis of the first connection portion 21. The electrical connector 70 extends along the first direction A. The third bonding strip 32 is located between the electrical connector 70 and the first connection portion 21. In this way, through the arrangement of the third bonding strip 32, the reliability of the connection between the electrical connector 70 and the first connection portion 21 can be further improved, thereby improving photoelectric conversion efficiency of the photovoltaic module.

Step 204: Form a second bonding layer on a surface of the second connection portion 22 away from the solar cell body 10 through the screen printing process, where the squeegee moves along the second direction B during the screen printing process, the second bonding layer includes one second bonding strip 40 having the strip-shaped structure, the second bonding strip 40 extends along the second direction B and intersects with the electrical connector 70, and the electrical connector 70 is electrically connected to the second connection portion 22 through the second bonding layer.

In this embodiment of the present application, the second bonding layer is arranged on the surface of the second connection portion 22 away from the solar cell body 10 through the screen printing process. The electrical connector 70 is connected to the second connection portion 22 through the second bonding layer, to improve reliability of the connection between the electrical connector 70 and the second connection portion 22.

In this embodiment of the present application, the second bonding layer includes the one second bonding strip 40 having the strip-shaped structure. The second bonding strip 40 extends along the second direction B. The squeegee moves along the second direction B during the screen printing process, so that the moving direction of the squeegee is the same as the extension direction of the second bonding strip 40. Through the foregoing arrangement, a height of the second bonding strip 40 is close to the height of the first bonding strips 31, so that the electrical connector 70 is not held up by the first bonding strips 31 or the second bonding strip 40, to help improve the reliability of the connection between the electrical connector 70 and the first connection portion 21 and the second connection portion 22, thereby ensuring the photoelectric conversion efficiency of the photovoltaic module.

Step 205: Provide the electrical connector, where the electrical connector 70 is arranged on the first bonding layer 30, and the electrical connector 70 extends along the first direction A and intersects with the at least two first bonding strips 31 having the strip-shaped structure, to be electrically connected to the first connection portion 21 through the first bonding layer 30.

The electrical connector 70 is also arranged on the second bonding layer. The electrical connector 70 extends along the first direction A. The electrical connector 70 intersects with the second bonding strip 40 and is electrically connected to the second connection portion 22 through the second bonding layer.

In this embodiment of the present application, the electrical connector 70 extends along the first direction A. The electrical connector 70 is arranged on a side of the first bonding layer 30 away from the first connection portion 21 and a side of the second bonding layer away from the second connection portion 22, so that the extension direction of the electrical connector 70 intersects with the extension direction of the first bonding strips 31 and the second bonding strip 40. The electrical connector 70 is connected to the first connection portion 21 through the first bonding layer 30, and the electrical connector 70 is connected to the second connection portion 22 through the second bonding layer. A contact area between the electrical connector 70 and the first bonding strips 31 and a contact area between the electrical connector 70 and the second bonding strip 40 are increased, thereby making the connection between the electrical connector 70 and the first bonding strips 31 more reliable and making the connection between the electrical connector 70 and the second bonding strip 40 also more reliable.

It should be noted that in this embodiment of the present application, the electrical connector 70 only includes a metal bar body, or the electrical connector 70 includes the metal bar body and a metal layer wrapping a surface of the metal bar body. In this embodiment of the present application, a specific structure of the electrical connector 70 is not excessively limited. In an actual application, a technician performs a setting according to a requirement.

It should be noted that, the embodiments in this specification are all described in a progressive manner. A description of each of the embodiments focuses on differences from other embodiments, and reference is made to each other for the same or similar parts among respective embodiments.

Although exemplary embodiments of the embodiments of the present application have been described, a person skilled in the art can make changes and modifications to the embodiments once the person skilled in the art learns about basic inventive concepts. Therefore, the following claims are intended to be construed as including the exemplary embodiments and all changes and modifications falling within the scope of the embodiments of the present application.

Finally, it should be noted that, the relational terms herein such as "first" and "second" are used only to differentiate an entity from another entity, and do not require or imply any actual relationship or sequence between the entities. In addition, the terms "include," "comprise," and any other variants are intended to cover non-exclusive inclusion, so that an object or a terminal device that includes a series of elements not only includes such elements, but also includes other elements not expressly listed, or further includes elements inherent to the object or the terminal device. If no more limitations are made, an element limited by "include a/an..." does not exclude other same elements existing in the object or the terminal device which includes the element.

The technical solutions provided in the present application are described above in detail. The principles and implementations of the present application are described by using specific examples in this specification. In addition, a person of ordinary skill in the art makes variations to the present application in terms of the specific implementations and application scopes according to the principles and implementations of the present application. In conclusion, the content of this specification should not be construed as a limitation to the present application.

## Claims

1. A photovoltaic module, comprising:
a solar cell body, wherein the solar cell body comprises a first surface and a second surface arranged opposite to each other;
a connection portion, wherein the connection portion is arranged on the first surface, the connection portion comprises a first connection portion and a second connection portion, the first connection portion and the second connection portion are arranged at intervals along a first direction, and an area of the first connection portion is larger than an area of the second connection portion;
a first bonding layer, wherein the first bonding layer is arranged on a surface of the first connection portion away from the solar cell body, the first bonding layer comprises at least two first bonding strips having a strip-shaped structure, the at least two first bonding strips extend along a second direction and are arranged at an interval along the first direction, and the second direction intersects with the first direction; and
an electrical connector, wherein the electrical connector is arranged on the first bonding layer, and the electrical connector extends along the first direction and intersects with the at least two first bonding strips having the strip-shaped structure, and the electrical connector is electrically connected to the first connection portion through the first bonding layer.

2. The photovoltaic module according to claim 1, wherein along the first direction, the first connection portion is located at a position close to an edge of the solar cell body; and
compared with the first connection portion, the second connection portion is located at a position relatively away from the edge of the solar cell body.

3. The photovoltaic module according to claim 1, wherein along the second direction, a width of the first connection portion is equal to a width of the second connection portion; and
along the first direction, a length of the first connection portion is larger than a length of the second connection portion.

4. The photovoltaic module according to any one of claims 1 to 3, wherein the photovoltaic module further comprises a second bonding layer, wherein
the second bonding layer is arranged on a surface of the second connection portion away from the solar cell body, the second bonding layer comprises one second bonding strip having the strip-shaped structure, the second bonding strip extends along the second direction and intersects with the electrical connector, and the electrical connector is electrically connected to the second connection portion through the second bonding layer.

5. The photovoltaic module according to claim 4, wherein a size of the second bonding strip is the same as a size of the first bonding strips.

6. The photovoltaic module according to claim 1, wherein the at least two first bonding strips are spaced apart from each other on the first connection portion; or
bottoms of the at least two first bonding strips are connected to each other on the first connection portion.

7. The photovoltaic module according to claim 1, wherein the first bonding strips extend along the second direction and have a rectangle-like structure; and/or
the first bonding strips extend along the second direction and have a racetrack structure.

8. The photovoltaic module according to claim 1, wherein the first bonding strips have a polygonal structure, wherein
a number of edges of the polygonal structure is 4N, N satisfying N≥2.

9. The photovoltaic module according to claim 1, wherein the first bonding layer further comprises a third bonding strip, wherein
the third bonding strip extends along the first direction, the third bonding strip is located on a central axis of the first connection portion, and the electrical connector covers the third bonding strip.

10. The photovoltaic module according to claim 9, wherein the first bonding layer has at least one of a 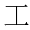 -shaped structure, a 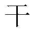 -shaped structure, a 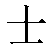 -shaped structure, and a 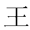 -shaped structure.

11. The photovoltaic module according to claim 1, wherein along the first direction, a width of the first bonding strips is smaller than a width of the second connection portion; and/or
along the second direction, a length of the first bonding strips is smaller than a length of the second connection portion.

12. The photovoltaic module according to claim 1, wherein the first surface is a back surface of the solar cell body.

13. A method for manufacturing a photovoltaic module, comprising:
providing a solar cell body, wherein the solar cell body comprises a first surface and a second surface arranged opposite to each other;
forming a connection portion on the first surface of the solar cell body through screen printing process, wherein the connection portion comprises a first connection portion and a second connection portion, the first connection portion and the second connection portion are arranged at intervals along a first direction, and an area of the first connection portion is larger than an area of the second connection portion;
forming a first bonding layer on a surface of the first connection portion away from the solar cell body through screen printing process, wherein a squeegee moves along a second direction during the screen printing process, the first bonding layer comprises at least two first bonding strips having a strip-shaped structure, the at least two first bonding strips extends along the second direction and are spaced apart from each other along the first direction, and the second direction intersects with the first direction; and
providing an electrical connector, disposing the electrical connector on the first bonding layer, wherein the electrical connector extends along the first direction and intersects with the at least two first bonding strips having the strip-shaped structure, and the electrical connector electrically connects to the first connection portion through the first bonding layer.

14. The method for manufacturing the photovoltaic module according to claim 13, wherein before the providing an electrical connector, disposing the electrical connector on the first bonding layer, wherein the electrical connector extends along the first direction and intersects with the at least two first bonding layers having the strip-shaped structure, and the electrical connector electrically connects to the first connection portion through the first bonding layer, the method further comprises:
forming a second bonding layer on a surface of the second connection portion away from the solar cell body through the screen printing process, wherein the squeegee moves along the second direction during the screen printing process, the second bonding layer comprises one second bonding strip having the strip-shaped structure, the second bonding strip extends along the second direction and intersects with the electrical connector, and the electrical connector electrically connects to the second connection portion through the second bonding layer.

15. The method for manufacturing the photovoltaic module according to claim 13, wherein the forming a first bonding layer on a surface of the first connection portion away from the solar cell body through the screen printing process, wherein a squeegee moves along a second direction during the screen printing process, the first bonding layer comprises at least two first bonding strips having a strip-shaped structure, the at least two first bonding strips extends along the second direction and are spaced apart from each other along the first direction, and the second direction intersects with the first direction further comprises:
forming a first bonding layer on a surface of the first connection portion away from the solar cell body through the screen printing process, wherein the squeegee moves along the second direction during the screen printing process, the first bonding layer comprises the at least two first bonding strips having the strip-shaped structure and a third bonding strip, the at least two first bonding strips extend along the second direction and are spaced apart from each other along the first direction, the third bonding strip extends along the first direction, and the third bonding strip is located on a central axis of the first connection portion.

16. A screen printing stencil, comprising: a plurality of mesh holes, wherein the plurality of meshes holes comprise at least two first meshes holes and a plurality of second meshes holes that are arranged at intervals along a first direction, the at least two first meshes holes are arranged adjacent to each other along the first direction, the at least two first meshes holes are configured to form first bonding strips, and the plurality of second meshes holes are configured to form a second bonding strip; and
along the first direction, a distance between two adjacent first meshes holes is less than a distance between two adjacent second meshes holes.
